# EUROPEAN PATENT APPLICATION

(11) **EP 4 800 906 A1**
(43) Date of publication of application: **02.09.2026**
(21) Application number: 24890460.9
(22) Date of filing: 24.10.2024
(51) Int. Cl.: H02M 7/00, H05K 7/20

(54) **POWER CONVERSION DEVICE**

(30) Priority: 16.11.2023 CN 202311551941
(71) Applicant: Huawei Digital Power Technologies Co., Ltd., Shenzhen, Guangdong 518043 (CN)
(72) Inventor: XIANG, Zhiqiang, Shenzhen, Guangdong 518043 (CN); MA, Bin, Shenzhen, Guangdong 518043 (CN); YAN, Zechun, Shenzhen, Guangdong 518043 (CN); SHI, Jipeng, Shenzhen, Guangdong 518043 (CN); LI, Maofan, Shenzhen, Guangdong 518043 (CN); WEN, Tao, Shenzhen, Guangdong 518043 (CN)
(74) Representative: Maiwald GmbH
(86) International application number: PCT/CN2024/126994
(87) International publication number: WO 2025/103103

(57) **Abstract**

A power conversion apparatus is provided, including a housing, a first circuit board, one or more switching transistors, one or more inductors, and a plurality of capacitors, where the first circuit board, the one or more switching transistors, the one or more inductors, and the plurality of capacitors are located in the housing. The first circuit board is disposed opposite to a base plate of the housing in a first direction. The one or more switching transistors, the one or more inductors, and the plurality of capacitors are all fastened to the first circuit board and are all located between the first circuit board and the base plate of the housing. The base plate of the housing includes a first chamber, a second chamber, and a third chamber that are sequentially communicated. The first chamber is configured to accommodate the plurality of capacitors, the second chamber is configured to accommodate the one or more switching transistors, and the third chamber is configured to accommodate the one or more inductors. In the first direction, a depth of the second chamber is less than a depth of the first chamber and less than a depth of the third chamber.

## Description

This application claims priority to Chinese Patent Application No. 202311551941.X, filed with the China National Intellectual Property Administration on November 16, 2023 and entitled "POWER CONVERSION APPARATUS", which is incorporated herein by reference in its entirety.

### TECHNICAL FIELD

This application relates to the photovoltaic energy field, and in particular, to a power conversion apparatus.

### BACKGROUND

An inverter can implement mutual conversion between an alternating current and a direct current, and such conversion is implemented by a related circuit including various semiconductor components. In a working process of the inverter, a power device in the inverter generates heat. A higher power of the inverter indicates a larger amount of heat generated by the power device. Currently, an entire inverter body is usually formed by assembling a sheet metal cover plate, a sheet metal chamber, an inductor heat dissipation shell, the power device, and the like, resulting in poor heat dissipation effect of the entire inverter.

### SUMMARY

A technical problem to be resolved in embodiments of this application is to provide a power conversion apparatus that can help improve a heat dissipation capability.

According to a first aspect, this application discloses a power conversion apparatus, including a housing, a first circuit board, one or more switching transistors, one or more inductors, and a plurality of capacitors, where the first circuit board, the one or more switching transistors, the one or more inductors, and the plurality of capacitors are located in the housing. The first circuit board is disposed opposite to a base plate of the housing in a first direction. The one or more switching transistors, the one or more inductors, and the plurality of capacitors are all fastened to the first circuit board and are all located between the first circuit board and the base plate. The base plate includes a first chamber, a second chamber, and a third chamber that are sequentially communicated. The first chamber is configured to accommodate the plurality of capacitors, the second chamber is configured to accommodate the one or more switching transistors, and the third chamber is configured to accommodate the one or more inductors. In the first direction, a depth of the second chamber is less than a depth of the first chamber and less than a depth of the third chamber.

The first chamber, the second chamber, and the third chamber are formed on the base plate, and in the first direction, the depth of the second chamber is less than the depth of the first chamber and less than the depth of the third chamber, to respectively adapt to shapes and sizes of the inductor, the capacitor, and the switching transistor. In comparison with the base plate being of a flat structure parallel to the first circuit board, the base plate on which different chambers are formed helps implement a compact layout of space in the housing and save space. This reduces an air volume ratio in the housing, shortens a heat conduction path from each of the switching transistor, the capacitor, and the inductor to the housing, helps more quickly transfer heat generated by the switching transistor, the capacitor, and the inductor in a working process from the housing to the outside of the housing, improves a heat dissipation capability of the entire power conversion apparatus, and improves power density of the power conversion apparatus. In addition, the first chamber and the third chamber are located on two sides of the second chamber, so that the capacitor and the inductor are disposed on two sides of the switching transistor, thereby reducing impact of heat generated by the inductor on the capacitor.

With reference to the first aspect, in a possible implementation, the housing includes a base plate, at least four side plates, and a cover plate. The cover plate is disposed opposite to the base plate in the first direction, and the at least four side plates are connected to edges of the cover plate and edges of the base plate. The base plate includes a plurality of bent structures and a plurality of flat structures. One end of a first bent structure is connected to a first side plate to enclose the first chamber, the other end of the first bent structure is connected to one end of a first flat structure, the first flat structure encloses the second chamber, the one or more switching transistors are located between the first flat structure and the first circuit board, the other end of the first flat structure is connected to a second bent structure, and the second bent structure encloses the third chamber.

In this possible implementation, the plurality of bent structures and the plurality of flat structures are formed on the base plate, the plurality of bent structures include the first bent structure and the second bent structure, and the first flat structure is connected between the first bent structure and the second bent structure, so that the first chamber correspondingly formed by the first bent structure, the second chamber enclosed by the first flat structure, and the third chamber enclosed by the second bent structure extend in the first direction with different depths. In comparison with the base plate being of a flat structure, the base plate provided with the bent structure helps implement a compact layout of space in the housing and save space. This reduces an air volume ratio in the housing, shortens heat conduction paths from each of the switching transistor, the capacitor, and the inductor to the housing, helps more quickly transfer heat generated by the switching transistor, the capacitor, and the inductor in a working process from the housing to the outside of the housing, improves the heat dissipation capability of the entire power conversion apparatus, and improves the power density of the power conversion apparatus.

With reference to the first aspect, in a possible implementation, the power conversion apparatus includes a fan, and the fan is disposed on a side that is of the first flat structure and that is away from the cover plate.

In this possible implementation, the fan is disposed on the side that is of the first flat structure and that is away from the cover plate, to accelerate air flowing on the side that is of the first flat structure and that is away from the cover plate. This improves heat dissipation efficiency of the switching transistor, the capacitor, and the inductor, and helps improve the heat dissipation capability and heat dissipation efficiency of the power conversion apparatus.

With reference to the first aspect, in a possible implementation, the base plate further includes heat dissipation fins, the heat dissipation fins are disposed on a surface of a side that is of the base plate and that is away from the cover plate; and in the first direction, the fan is disposed opposite to the heat dissipation fins disposed on the first flat structure.

In this possible implementation, the heat dissipation fins are integrated on the surface of the side that is of the base plate and that is away from the cover plate, to improve the heat dissipation capability of the power conversion apparatus. In addition, the heat dissipation fins on the first flat structure are disposed opposite to the fan in the first direction, to enhance air flowing around the heat dissipation fins around the first flat structure, and further improve the heat dissipation capability and the heat dissipation efficiency of the power conversion apparatus.

With reference to the first aspect, in a possible implementation, the first bent structure includes a first connection part and a first protrusion part, the first connection part is connected between the first protrusion part and the first side plate, the first connection part is farther away from the cover plate in the first direction relative to the first flat structure, one end that is of the first protrusion part and that is away from the first connection part is connected to the first flat structure, the first protrusion part protrudes toward the cover plate in the first direction relative to the first connection part, the first side plate, the first connection part, and the first protrusion part enclose the first chamber, and the plurality of capacitors are accommodated between the first connection part and the first circuit board.

In this possible implementation, the first bent structure includes the first protrusion part that protrudes toward the cover plate in the first direction and the first connection part. The first connection part is farther away from the cover plate in the first direction relative to the first flat structure, that is, in the first direction, the depth of the second chamber is less than the depth of the first chamber, so that a gap between the one or more switching transistors in the second chamber and the first flat structure becomes smaller. This shortens a heat conduction path from the switching transistor to the base plate, and improves the heat dissipation capability of the power conversion apparatus.

With reference to the first aspect, in a possible implementation, the second bent structure includes a second connection part and a second protrusion part, the second connection part is farther away from the cover plate in the first direction relative to the first flat structure, the second protrusion part protrudes toward the cover plate in the first direction relative to the second connection part, the second protrusion part is connected between the first flat structure and the second connection part, the second connection part and the second protrusion part enclose the third chamber, and the one or more inductors are accommodated between the second connection part and the first circuit board.

In this possible implementation, the second bent structure includes the second protrusion part that protrudes toward the cover plate in the first direction and the second connection part. The second connection part is farther away from the cover plate in the first direction relative to the first flat structure. That is, in the first direction, the depth of the third chamber is greater than the depth of the second chamber, and a large inductor may be disposed in the third chamber. This helps improve power density of the power conversion apparatus. In addition, heat generated by the inductor in the third chamber may be dissipated to the outside of the housing through the second connection part and the second protrusion part, and the second connection part and the second protrusion part are fully used to dissipate the heat of the inductor, thereby improving the heat dissipation capability of the power conversion apparatus. In addition, the third chamber is configured to accommodate the inductor, and sizes of an input inductor and an output inductor may be set to be the same, thereby simplifying a provision structure of the inductor.

With reference to the first aspect, in a possible implementation, the second bent structure further includes a third protrusion part connected to the second connection part, the third protrusion part protrudes toward the cover plate in the first direction relative to the second connection part, the third protrusion part is disposed opposite to the second protrusion part, and the third protrusion part, the second connection part, and the second protrusion part enclose the third chamber.

In this possible implementation, two opposite ends of the second connection part are respectively connected to the third protrusion part and the second protrusion part, and the third protrusion part separates the third chamber from a chamber that is in the housing and that is away from the first side plate, thereby helping reduce impact of heat generated by the inductor on another device in the housing.

With reference to the first aspect, in a possible implementation, the base plate further includes a second flat structure, the second flat structure is connected to the second bent structure, the second flat structure is farther away from the cover plate in the first direction relative to the first flat structure, and the second flat structure encloses a fourth chamber. The power conversion apparatus further includes a direct current switch and a relay, both the direct current switch and the relay are disposed on the first circuit board and extend toward the base plate in the first direction, and both the direct current switch and the relay are accommodated in the fourth chamber.

In this possible implementation, the second flat structure is farther away from the cover plate in the first direction relative to the first flat structure, so that a depth of the fourth chamber enclosed by the second flat structure in the first direction is greater than the depth of the second chamber in the first direction. The fourth chamber may accommodate a device with a small amount of generated heat, such as the direct current switch and the relay, and the depth of the fourth chamber may be determined based on heights of the direct current switch and the relay that extend toward the first direction. This reduces an air volume ratio in the fourth chamber, allows heat in the fourth chamber to be more quickly dissipated from the second flat structure to the outside of the housing, and improves the heat dissipation capability of the power conversion apparatus.

With reference to the first aspect, in a possible implementation, the base plate further includes a third bent structure, the third bent structure includes a third connection part and a fourth protrusion part that are connected, the third connection part is farther away from the cover plate in the first direction relative to the second flat structure, the fourth protrusion part protrudes toward the cover plate in the first direction relative to the third connection part, the fourth protrusion part is connected between the second flat structure and the third connection part, one end of the third connection part is connected to a second side plate, the second side plate is disposed opposite to the first side plate, and the third connection part, the fourth protrusion part, and the second side plate enclose a fifth chamber. The power conversion apparatus further includes a second circuit board, the second circuit board is connected to and disposed perpendicular to the first circuit board, and the second circuit board is accommodated in the fifth chamber.

In this possible implementation, the third connection part is farther away from the cover plate in the first direction relative to the second flat structure, and a depth of the fifth chamber in the first direction is greater than the depth of the fourth chamber in the first direction, so that the second circuit board perpendicular to the first circuit board is disposed in the fifth chamber, and heat emitted by the second circuit board may be dissipated to the outside of the housing through the fourth protrusion part, the third connection part, and the second side plate. In addition, the second circuit board is close to the second side plate. This helps the second circuit board penetrate the second side plate and be electrically connected to an external circuit, reduces an internal cable layout, and simplifies assembly. The first circuit board and the second circuit board may be electrically connected through a gold finger, to implement a cable-free assembly design between internal circuit boards, simplify an assembly process, improve manufacturing efficiency, and help reduce manufacturing costs of the power conversion apparatus. In addition, the fourth protrusion part protrudes toward the cover plate in the first direction relative to the second flat structure, and is connected between the second flat structure and the third connection part, that is, there is no baffle plate spaced on a side that is of the fourth chamber and that faces the fifth chamber, so that a device in the fourth chamber extends into the fifth chamber and is electrically connected to the second circuit board.

With reference to the first aspect, in a possible implementation, the power conversion apparatus further includes a plurality of through-wall terminals, and the plurality of through-wall terminals penetrate the second side plate and are connected to the second circuit board.

In this possible implementation, the plurality of through-wall terminals are configured to implement an electrical connection between the second circuit board and the external circuit, and no cable needs to be disposed between the second circuit board and the external circuit. This simplifies an assembly process between circuit boards, improves manufacturing efficiency, and helps reduce manufacturing costs of the power conversion apparatus.

With reference to the first aspect, in a possible implementation, the base plate, the first side plate, and the second side plate are of integrally formed structure.

In this possible implementation, the first side plate is fastened to the base plate, and the first side plate, the second side plate, and the base plate are integrated into one. This simplifies a structure form of the housing, and helps reduce manufacturing costs of the power conversion apparatus. In addition, no sealing rubber needs to be disposed at a joint between the first side plate and the base plate, and a joint between the second side plate and the base plate. In this way, a heat conduction path of heat in the first chamber through the first side plate and the base plate, and a heat conduction path of the second side plate and the base plate are shorter, and devices in the housing can share the heat dissipation capability, helping improve the heat dissipation capability of the power conversion apparatus.

### BRIEF DESCRIPTION OF DRAWINGS

To describe technical solutions in embodiments of this application or in the background more clearly, the following describes the accompanying drawings for describing embodiments of this application or the background.
FIG. 1 is a diagram of networking of a photovoltaic energy storage system in a large-scale ground power station or industrial and commercial application scenario according to an embodiment of this application;
FIG. 2 is a diagram of a three-dimensional structure of a power conversion apparatus according to an embodiment of this application;
FIG. 3 is a diagram of a partial structure of the power conversion apparatus shown in FIG. 2 from a perspective;
FIG. 4 is a plan view of the power conversion apparatus shown in FIG. 3;
FIG. 5 is a front view of a partial structure of the power conversion apparatus shown in FIG. 2;
FIG. 6 is a diagram of a partial structure of the power conversion apparatus shown in FIG. 5 from a perspective; and
FIG. 7 is a diagram of a three-dimensional structure of a power conversion apparatus according to an embodiment of this application.

### Reference numerals:

A: first direction; B: second direction; C: third direction; 100: power conversion apparatus; 200: photovoltaic module; 300: photovoltaic inverter; 400: box-type transformer station; 500: booster station; 600: power grid; 700: energy storage system; 800: power conversion system; 10: housing; 11: base plate; 111: recess part; 112: first flat structure; 113: second flat structure; 114: first bent structure; 1141: first connection part; 1142: first protrusion part; 115: second bent structure; 1151: second connection part; 1152: second protrusion part; 1153: third protrusion part; 116: third bent structure; 1161: third connection part; 1162: fourth protrusion part; 12: side plate; 121: first side plate; 122: second side plate; 123: third side plate; 124: fourth side plate; 125: notch; 13: cover plate; 14: plug hole; 15: heat dissipation fin; 16: internal chamber; 161: first chamber; 162: second chamber; 163: third chamber; 164: fourth chamber; 165: fifth chamber; 20: fan; 30: direct current switch; 40: through-wall terminal; 50a: first circuit board; 50b: second circuit board; 60: switching transistor; 70: inductor; 80: capacitor; 90: relay.

### DESCRIPTION OF EMBODIMENTS

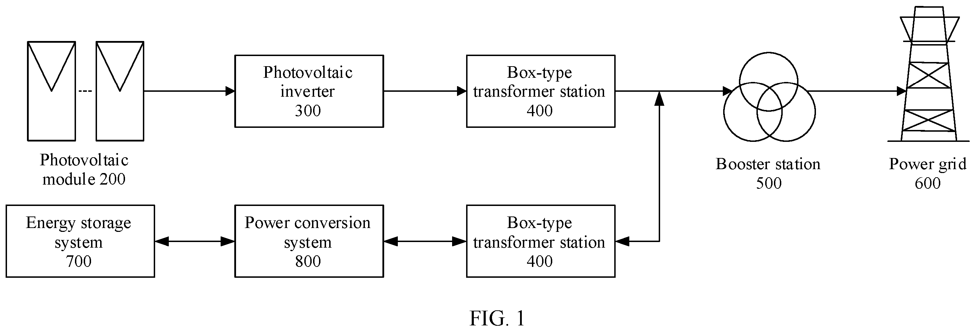

FIG. 1 is a diagram of networking of a photovoltaic energy storage system in a large-scale ground power station or industrial and commercial application scenario according to an embodiment of this application. A photovoltaic module 200 converts solar energy into a direct current through photovoltaic effect, and a photovoltaic inverter 300 converts the direct current output by the photovoltaic module 200 into an alternating current, and further transfers the alternating current to a box-type transformer station 400. The box-type transformer station 400 converts the low-voltage alternating current output by the photovoltaic inverter 300 into a medium-voltage alternating current, and further transfers the medium-voltage alternating current to a booster station 500 (power grid 600) or to a box-type transformer station 400 corresponding to an energy storage system 700. The energy storage system 700 is configured to: store unstable electric energy from the photovoltaic module 200, and output stable electric energy to the power grid 600 through a power conversion system 800 and the corresponding box-type transformer station 400.

In the photovoltaic energy storage system shown in FIG. 1, the photovoltaic inverter 300 and the power conversion system 800 are core devices for power conversion, and are collectively referred to as a power conversion apparatus 100. The following specifically describes, with reference to the accompanying drawings, a structure of the power conversion apparatus 100 provided in this application. It should be noted that the power conversion apparatus 100 provided in this application may be further used in a residential photovoltaic system. Because a networking manner of the residential photovoltaic system is similar to that in FIG. 1, details are not described in this application again.

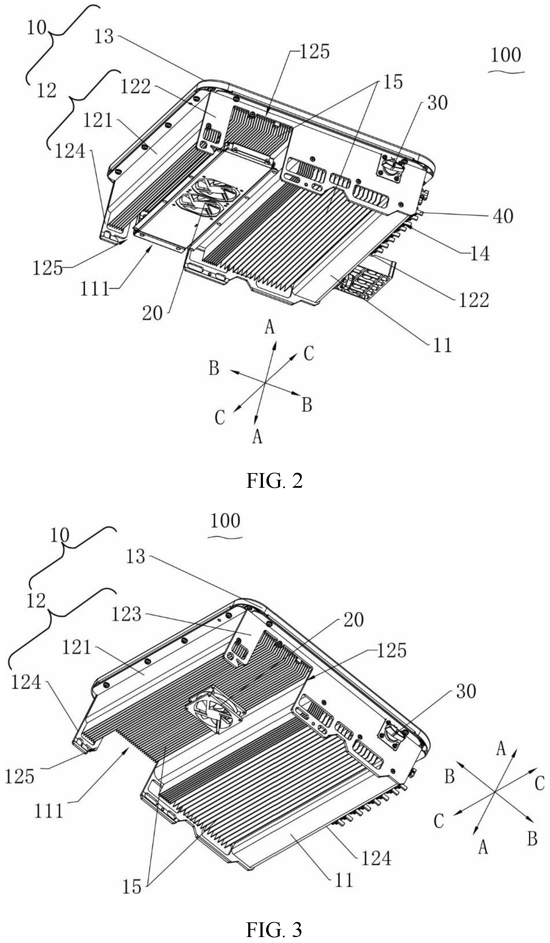

FIG. 2 is a diagram of a three-dimensional structure of a power conversion apparatus 100 according to an embodiment of this application. The power conversion apparatus 100 includes a housing 10, heat dissipation fins 15, a fan 20, a direct current switch 30, and through-wall terminals 40. The heat dissipation fins 15 are disposed on a base plate 11, and the heat dissipation fins 15 are configured to dissipate heat for the power conversion apparatus 100. The fan 20 is connected to the housing 10, the fan 20 is disposed opposite to the heat dissipation fins 15, and the fan 20 is configured to enhance air flowing around the heat dissipation fins 15. Both the direct current switch 30 and the through-wall terminal 40 partially extend out of the housing 10.

The housing 10 includes the base plate 11, at least four side plates 12, a cover plate 13, and a plug hole 14. The base plate 11 is disposed opposite to the cover plate 13 in a first direction A, the at least four side plates 12 are connected to edges of the base plate 11 and edges of the cover plate 13, the plug hole 14 may be disposed on any one of the at least four side plates 12, and the plug hole 14 penetrates the housing 10 and is configured to internally connect the power conversion apparatus 100 to an external circuit board.

Optionally, the housing 10 may be integrally formed by using an aluminum profile, so that heat conduction and heat dissipation capabilities of the housing 10 can be improved.

A recess part 111 is formed on the base plate 11, and the heat dissipation fins 15 are disposed on a plurality of side walls that enclose the recess part 111. A notch 125 is formed at each of a position of a third side plate 123 corresponding to the recess part 111 and a position of a fourth side plate 124 corresponding to the recess part 111, and the notch 125 communicates with the recess part 111. Provision of the recess part 111 helps reduce a volume of the housing 10, thereby implementing a lightweight design of the power conversion apparatus 100.

Joints between the cover plate 13 and the at least four side plates 12 may be sealed by using sealing gaskets, to implement high protection sealing in the power conversion apparatus 100. A quantity of side plates 12 may be four, the four side plates 12 are respectively a first side plate 121, a second side plate 122, the third side plate 123, and the fourth side plate 124, and the four side plates 12, the base plate 11, and the cover plate 13 jointly enclose the housing 10 of a rectangular shape. It may be understood that the quantity of side plates 12 may be more than four, to enclose the housing 10 of a polygonal shape.

The first side plate 121 is disposed at one end of the base plate 11 in a second direction B, the second side plate 122 is disposed at the other end of the base plate 11 in the second direction B, and the first side plate 121 is opposite to the second side plate 122 in the second direction B. The third side plate 123 is disposed at one end of the base plate 11 in a third direction C, the fourth side plate 124 is disposed at the other end of the base plate 11 in the third direction C, and the third side plate 123 is opposite to the fourth side plate 124 in the third direction C. The plug hole 14 may be disposed on any one of the first side plate 121, the second side plate 122, the third side plate 123, and the fourth side plate 124.

It should be noted that the first direction A may be a height direction of the power conversion apparatus 100, the second direction B may be a length direction of the power conversion apparatus 100, the third direction C may be a width direction of the power conversion apparatus 100, and the first direction A, the second direction B, and the third direction C are perpendicular to each other.

The first side plate 121, the second side plate 122, and the base plate 11 are of an integrally formed structure, and the first side plate 121, the second side plate 122, and the base plate 11 are integrated into one. This simplifies a structure form of the housing 10, and helps reduce manufacturing costs of the power conversion apparatus 100. In addition, no sealing rubber needs to be disposed at a joint between the first side plate 121 and the base plate 11 and a joint between the second side plate 122 and the base plate 11. In this way, a heat conduction path of heat in the power conversion apparatus 100 through the first side plate 121 and the base plate 11 and a heat conduction path of the second side plate 122 and the base plate 11 are shorter, and power devices can share a heat dissipation capability, helping improve the heat dissipation capability of the power conversion apparatus 100.

Both the third side plate 123 and the fourth side plate 124 are connected to the first side plate 121 and the second side plate 122. In other words, the third side plate 123 is connected to both the first side plate 121 and the second side plate 122, and the fourth side plate 124 is connected to both the first side plate 121 and the second side plate 122. A sealing gasket is disposed at each of a joint between the third side plate 123 and the first side plate 121, a joint between the third side plate 123 and the second side plate 122, a joint between the fourth side plate 124 and the first side plate 121, and a joint between the fourth side plate 124 and the second side plate 122, to implement high protection sealing in the power conversion apparatus 100.

The heat dissipation fins 15 are disposed on a side that is of the base plate 11 and that is away from the cover plate 13 in the first direction A. The heat dissipation fins 15 and the cover plate 13 are located on two opposite sides of the base plate 11 in the first direction A. The heat dissipation fins 15 are integrated on the base plate 11, so that the heat dissipation capability of the power conversion apparatus 100 is further improved through the heat dissipation fins 15.

In comparison with independently disposing a heat sink and the housing 10, integrating the heat dissipation fins 15 and the housing 10 together helps share a heat dissipation capability by each power device that emits heat in the housing 10, and helps improve the heat dissipation capability of the power conversion apparatus 100. In addition, the heat dissipation fins 15 and the housing 10 are integrated together, so that an assembly process between devices can be reduced, and production efficiency of the entire power conversion apparatus 100 can be improved.

In an implementation, in the first direction A, both a height of the third side plate 123 and a height of the fourth side plate 124 are greater than heights of the heat dissipation fins 15, there is a height difference between the third side plate 123 and the heat dissipation fins 15, and there is a height difference between the fourth side plate 124 and the heat dissipation fins 15. Heat dissipated by the heat dissipation fins 15 to the outside of the power conversion apparatus 100 may be dissipated through the third side plate 123 and the fourth side plate 124.

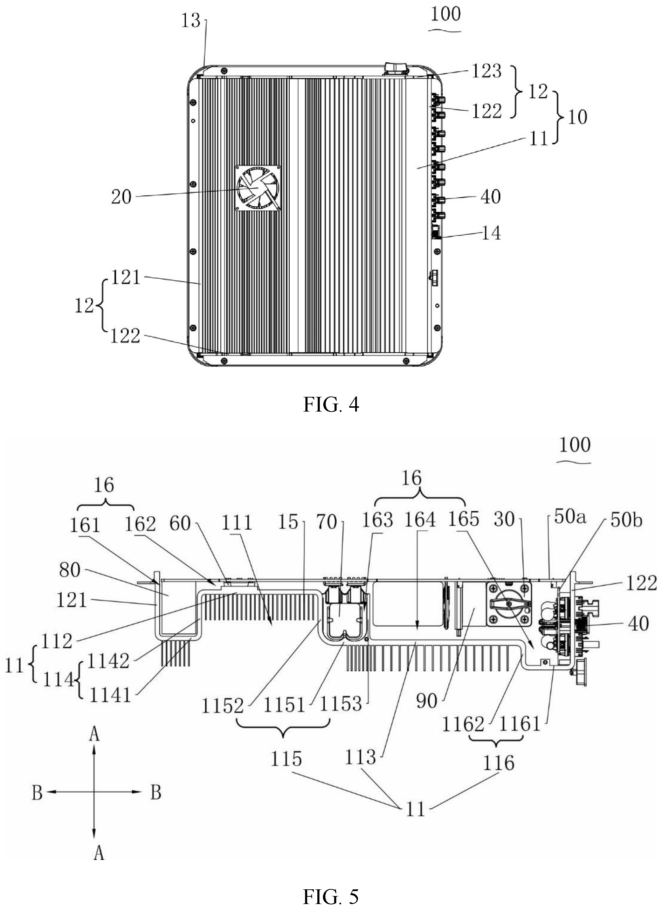

With reference to FIG. 3 and FIG. 4, in an implementation, the fan 20 is located in the recess part 111, and the fan 20 may be fastened to the third side plate 123 and the fourth side plate 124. The fan 20 is disposed in the recess part 111, so that an overall structure of the power conversion apparatus 100 has a compact layout. The fan 20 is opposite to the heat dissipation fins 15 in the recess part 111. This enhances air flowing around the heat dissipation fins 15, improves the heat dissipation capability of the power conversion apparatus 100, and improves heat dissipation efficiency of the power conversion apparatus 100.

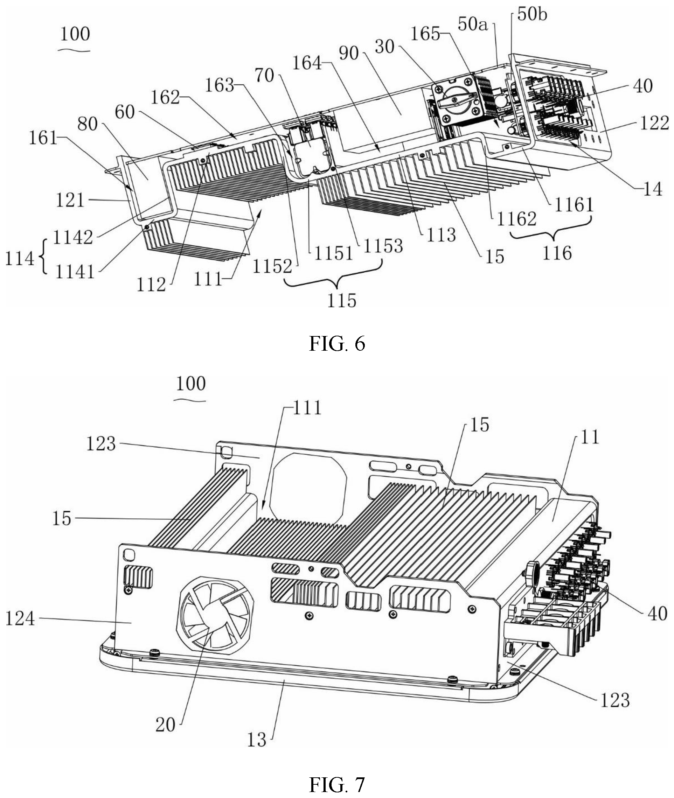

Refer to FIG. 5 and FIG. 6. The power conversion apparatus 100 further includes a first circuit board 50a, a second circuit board 50b, one or more switching transistors 60, one or more inductors 70, a plurality of capacitors 80, and a relay 90 that are located in the housing 10. The first circuit board 50a is of a flat structure perpendicular to the first direction A, the first circuit board 50a is fastened to the housing 10, the first circuit board 50a is electrically connected to the second circuit board 50b, and the first circuit board 50a is disposed perpendicular to the second circuit board 50b. The one or more switching transistors 60, the one or more inductors 70, the plurality of capacitors 80, and the relay 90 are all electrically connected to the first circuit board 50a. The one or more switching transistors 60, the one or more inductors 70, the plurality of capacitors 80, and the relay 90 all extend toward the base plate 11 in the first direction A.

The base plate 11, the at least four side plates 12, and the cover plate 13 jointly enclose an inner chamber 16. The inner chamber 16 includes a first chamber 161, a second chamber 162, a third chamber 163, a fourth chamber 164, and a fifth chamber 165 that are sequentially arranged and communicated in the second direction B. The first circuit board 50a extends from the first chamber 161 to the fifth chamber 165. The plurality of capacitors 80 are accommodated in the first chamber 161. The one or more switching transistors 60 are accommodated in the second chamber 162. The one or more inductors 70 are accommodated in the third chamber 163. The direct current switch 30 and the relay 90 are accommodated in the fourth chamber 164. The second circuit board 50b is accommodated in the fifth chamber 165.

In the first direction A, a depth of the second chamber 162 is less than a depth of the first chamber 161 and less than a depth of the third chamber 163, to respectively adapt to shapes and sizes of the inductor 70, the capacitor 80, and the switching transistor 60. In comparison with the base plate 11 being of a flat structure parallel to the first circuit board 50a, the base plate 11 on which different chambers are formed helps implement a compact layout of space in the housing 10 and save space. This reduces an air volume ratio in the housing 10, shortens a heat conduction path from each of the switching transistor 60, the capacitor 80, and the inductor 70 to the housing 10, helps more quickly transfer heat generated by the switching transistor 60, the capacitor 80, and the inductor 70 in a working process from the housing 10 to the outside of the housing 10, improves the heat dissipation capability of the entire power conversion apparatus 100, and improves power density of the power conversion apparatus 100.

The base plate 11 includes a plurality of flat structures and a plurality of bent structures. The plurality of flat structures of the base plate 11 include a first flat structure 112 and a second flat structure 113. The plurality of bent structures include a first bent structure 114, a second bent structure 115, and a third bent structure 116.

The first bent structure 114, the first flat structure 112, the second bent structure 115, the second flat structure 113, and the third bent structure 116 are sequentially arranged in the second direction B. In other words, one end of the first bent structure 114 is connected to the first side plate 121, and the other end of the first bent structure 114 is connected to the first flat structure 112; the other end of the first flat structure 112 is connected to one end of the second bent structure 115; the other end of the second bent structure 115 is connected to one end of the second flat structure 113; the other end of the second flat structure 113 is connected to one end of the third bent structure 116; and the other end of the third bent structure 116 is connected to the second side plate 122.

The first bent structure 114 and the first side plate 121 enclose the first chamber 161, the first flat structure 112 encloses the second chamber 162, the second bent structure 115 encloses the third chamber 163, the second flat structure 113 encloses the fourth chamber 164, and the third bent structure 116 and the second side plate 122 enclose the fifth chamber 165.

The plurality of bent structures and the plurality of flat structures are formed on the base plate 11, and the base plate 11 is set to a high-low recess-protrusion structure, so that the first chamber 161 correspondingly enclosed by the first bent structure 114, the second chamber 162 enclosed by the first flat structure 112, and the third chamber 163 enclosed by the second bent structure 115 extend in the first direction A with different depths, to respectively adapt to layout matching sizes of the inductor 70, the capacitor 80, and the switching transistor 60. In comparison with the base plate 11 being of a flat structure parallel to the first circuit board 50a, the base plate 11 provided with the bent structure helps implement a compact space layout of the inner chamber 16 and save space. This reduces an air volume ratio in the housing 10, shortens a heat conduction path from each of the switching transistor 60, the capacitor 80, and the inductor 70 to the housing 10, helps more quickly transfer heat generated by the switching transistor 60, the capacitor 80, and the inductor 70 in a working process from the housing 10 to the outside of the housing 10, improves the heat dissipation capability of the entire power conversion apparatus 100, and helps improve the power density of the power conversion apparatus 100. In addition, the first bent structure 114 and the second bent structure 115 are respectively connected to two ends of the first flat structure 112, that is, the first chamber 161 and the third chamber 163 are located on two sides of the second chamber 162, so that the capacitor 80 and the inductor 70 are disposed on two sides of the switching transistor 60, thereby helping reduce impact of heat generated by the inductor 70 on the capacitor 80.

Specifically, the first flat structure 112 and a part of the cover plate 13 corresponding to the first flat structure 112 jointly enclose the second chamber 162. A depth of the second chamber 162 in the first direction A is determined based on a height of the one or more switching transistors 60 extending in the first direction A, to adapt to a shape and a size of the one or more switching transistors 60.

The first flat structure 112 is disposed opposite to the first circuit board 50a in the third direction C. For example, both the first flat structure 112 and the first circuit board 50a are flat structures perpendicular to the first direction A. For another example, the first flat structure 112 is disposed obliquely relative to the first circuit board 50a. This may be specifically determined based on a layout of the one or more switching transistors 60 in the second chamber 162.

The second flat structure 113 and a part of the cover plate 13 corresponding to the second flat structure 113 jointly enclose the fourth chamber 164. The second flat structure 113 is disposed in parallel with the first flat structure 112. For example, the second flat structure 113 is a flat structure perpendicular to the first direction A.

The second flat structure 113 is farther away from the cover plate 13 in the first direction A relative to the first flat structure 112, that is, in the first direction A, a depth of the fourth chamber 164 is greater than the depth of the second chamber 162, which may be specifically determined based on a height at which the direct current switch 30 and the relay 90 extend in the first direction A. This reduces an air volume ratio in the fourth chamber 164, allows heat in the fourth chamber 164 to be dissipated from the second flat structure 113 to the outside of the housing 10 more quickly, and improves the heat dissipation capability of the power conversion apparatus 100.

The heat dissipation fins 15 are disposed on surfaces of sides that are of the first flat structure 112 and the second flat structure 113 and that are away from the cover plate 13 in the first direction A, to improve heat dissipation capabilities and heat dissipation efficiency of the first flat structure 112 and the second flat structure 113. In addition, the fan 20 is disposed on the side that is of the first flat structure 112 and that is away from the cover plate 13, to accelerate air flowing on the side that is of the first flat structure 112 and that is away from the cover plate 13. This improves heat dissipation efficiency of the switching transistor 60, the capacitor 80, and the inductor 70, and helps improve the heat dissipation capability and the heat dissipation efficiency of the power conversion apparatus 100.

In the first direction A, the fan 20 is disposed opposite to heat dissipation fins 15 disposed on the first flat structure 112, to enhance air flowing around the heat dissipation fins 15 around the first flat structure 112, and further improve the heat dissipation capability and the heat dissipation efficiency of the power conversion apparatus 100.

The first bent structure 114 includes a first connection part 1141 and a first protrusion part 1142, the first connection part 1141 is connected between the first protrusion part 1142 and the first side plate 121, one end that is of the first protrusion part 1142 and that is away from the first connection part 1141 is connected to the first flat structure 112, the first connection part 1141, the first side plate 121, and the first protrusion part 1142 jointly enclose the first chamber 161, and the plurality of capacitors 80 are accommodated in the first chamber 161 and located between the first connection part 1141 and the first circuit board 50a.

The first connection part 1141 may be parallel to the first flat structure 112, and the first connection part 1141 is farther away from the cover plate 13 in the first direction A relative to the first flat structure 112, that is, in the first direction A, the depth of the second chamber 162 is less than the depth of the first chamber 161, so that a gap between the one or more switching transistors 60 in the second chamber 162 and the first flat structure 112 becomes smaller. This shortens a heat conduction path from the switching transistor 60 to the base plate 11, and improves the heat dissipation capability of the power conversion apparatus 100.

The first protrusion part 1142 protrudes toward the cover plate 13 in the first direction A relative to the first connection part 1141. In an implementation, the first connection part 1141 is perpendicular to both the first side plate 121 and the first protrusion part 1142, and the first bent structure 114 as a whole is an "L"-shaped structure.

In an implementation, heat dissipation fins 15 are disposed on a surface of a side that is of the first connection part 1141 and/or the first protrusion part 1142 and that is away from the first chamber 161, to improve a heat dissipation capability and heat dissipation efficiency of the first connection part 1141 and/or the first protrusion part 1142.

The second bent structure 115 includes a second connection part 1151, a second protrusion part 1152, and a third protrusion part 1153. The second protrusion part 1152 and the third protrusion part 1153 are respectively connected to two opposite ends of the second connection part 1151. The second protrusion part 1152, the second connection part 1151, and the third protrusion part 1153 jointly enclose the third chamber 163. The one or more inductors 70 are accommodated in the third chamber 163 and located between the second connection part 1151 and the first circuit board 50a.

The second connection part 1151 may be parallel to the first flat structure 112, and the second connection part 1151 is farther away from the cover plate 13 in the first direction A relative to the first flat structure 112. That is, the depth of the third chamber 163 in the first direction A is greater than the depth of the second chamber 162 in the first direction A, and a large inductor 70 may be disposed in the third chamber 163. This helps improve the power density of the power conversion apparatus 100.

An inner wall surface of the second connection part 1151 facing the third chamber 163 may be set as a curved surface, and matches a shape profile of the inductor 70, so that spacings between each position of the inductor 70 and the inner wall surface of the second connection part 1151 facing the third chamber 163 are equal. This helps shorten a heat conduction path between the inductor 70 and the second connection part 1151, and improves a heat dissipation capability. When the third chamber 163 is filled with a thermally conductive material, a disposing amount of the thermally conductive material can be effectively reduced, and heat dissipation costs can be reduced.

In an implementation, in the first direction A, a distance between the second connection part 1151 and the first circuit board 50a is less than or equal to a distance between the first connection part 1141 and the first circuit board 50a.

In another implementation, in the first direction A, the distance between the second connection part 1151 and the first circuit board 50a is greater than the distance between the first connection part 1141 and the first circuit board 50a. In this way, the depth of the third chamber 163 in the first direction A is greater than the depth of the first chamber 161 in the first direction A, so that a larger inductor 70 in the third chamber 163 may be disposed. This helps improve the power density of the power conversion apparatus 100. In addition, the third chamber 163 is configured to accommodate the inductor 70, and sizes of an input inductor and an output inductor may be set to be the same, thereby simplifying a provision structure of the inductor 70.

The second connection part 1151 is further connected to the second flat structure 113, and the third protrusion part 1153 is connected to a joint between the second connection part 1151 and the second flat structure 113.

The second protrusion part 1152 protrudes toward the cover plate 13 in the first direction A relative to the second connection part 1151, the second protrusion part 1152 is connected between the first flat structure 112 and the second connection part 1151, the second protrusion part 1152 and the second connection part 1151 as a whole are of an "L"-shaped structure, and the second protrusion part 1152 and the first protrusion part 1142 are opposite to each other and spaced in the second direction B. In this way, when heat in the first chamber 161 is transferred from the first protrusion part 1142 to the outside of the housing 10, impact on the inductor 70 in the third chamber 163 can be reduced. Similarly, when heat in the third chamber 163 is transferred from the second protrusion part 1152 to the outside of the housing 10, impact on the capacitor 80 in the first chamber 161 can also be reduced.

Heat generated by the inductor 70 in the third chamber 163 may be dissipated to the outside of the housing 10 through the second connection part 1151 and the second protrusion part 1152, and the second connection part 1151 and the second protrusion part 1152 are fully used to dissipate heat of the inductor 70, thereby improving the heat dissipation capability of the power conversion apparatus 100.

In an implementation, the heat dissipation fins 15 are disposed on a surface of a side that is of the second connection part 1151 and/or the second protrusion part 1152 and that is away from the third chamber 163, to improve a heat dissipation capability and heat dissipation efficiency of the second connection part 1151 and/or the second protrusion part 1152. The first protrusion part 1142, the first flat structure 112, and the second protrusion part 1152 enclose the recess part 111 at a side away from the inner chamber 16.

The third protrusion part 1153 protrudes toward the cover plate 13 in the first direction A relative to the second connection part 1151. On a side that is of the third protrusion part 1153 and that faces the first protrusion part 1142 in the second direction B, the third protrusion part 1153, the second connection part 1151, and the second protrusion part 1152 enclose the third chamber 163. On a side that is of the third protrusion part 1153 and that is away from the first protrusion part 1142 in the second direction B, the third protrusion part 1153 and the second flat structure 113 enclose the fourth chamber 164. That is, the third protrusion part 1153 separates the third chamber 163 from the fourth chamber 164. This helps reduce impact of heat generated by the inductor 70 on the relay 90 and the direct current switch 30 in the fourth chamber 164.

In an implementation, a height of the third protrusion part 1153 protruding in the first direction A may be equal to a height of the second protrusion part 1152 protruding in the first direction A.

In an implementation, a spacing between an inner wall surface of the second connection part 1151 and the inductor 70, a spacing between an inner wall surface of the second protrusion part 1152 and the inductor 70, and a spacing between a wall surface of a side that is of the third protrusion part and that faces the inductor 70 and the inductor 70 are all the same, and a value of the spacing may be designed according to an insulation requirement and a voltage. When an insulation material is disposed on an outer surface of the inductor 70, the value of the spacing may be set to 0. In other words, the inductor 70 is attached to the second connection part 1151, the second protrusion part 1152, and the third protrusion part 1153, to shorten a heat conduction path between the inductor 70 and the base plate 11. When no insulation material is disposed on an outer surface of the inductor 70, the value of the spacing may be set based on a voltage required by the inductor 70. For example, when a value of the voltage is 200 V, the value of the spacing may be set to 1 mm; or when a value of the inductance is 400 V, the value of the spacing may be set to 2 mm.

The third bent structure 116 includes a third connection part 1161 and a fourth protrusion part 1162. Two opposite ends of the third connection part 1161 are respectively connected to the fourth protrusion part 1162 and the second side plate 122. The third connection part 1161, the fourth protrusion part 1162, and the second side plate 122 jointly enclose the fifth chamber 165. A part of the through-wall terminals 40 and the second circuit board 50b are accommodated in the fifth chamber 165 and located between the third connection part 1161 and the first circuit board 50a. The through-wall terminal 40 is electrically connected to the second circuit board 50b.

The third connection part 1161 is farther away from the cover plate 13 in the first direction A relative to the second flat structure 113, that is, a depth of the fifth chamber 165 in the first direction A is greater than the depth of the fourth chamber 164 in the first direction A, so that the second circuit board 50b perpendicular to the first circuit board 50a can be disposed in the fifth chamber 165. A distance between the third connection part 1161 and the first circuit board 50a in the first direction A may be determined based on a height of the second circuit board 50b in the first direction A, to reduce an air volume ratio in the fifth chamber 165 and improve a heat dissipation capability.

The fourth protrusion part 1162 is connected to the third connection part 1161 and the second flat structure 113. The fourth protrusion part 1162 protrudes from the third connection part 1161 toward the cover plate 13 in the first direction A, and the third connection part 1161 and the fourth protrusion part 1162 are of an "L"-shaped structure as a whole. Relative to a fact that a direction in which the fourth protrusion part 1162 extends from the third connection part 1161 toward a side of the cover plate 13 derives from the first direction A, the fourth protrusion part 1162 extends in the first direction A. This reduces an air volume ratio in the fifth chamber 165, and improves the heat dissipation capability of the power conversion apparatus 100.

In addition, the fourth protrusion part 1162 protrudes toward the cover plate 13 in the first direction A relative to the second flat structure 113, and is connected between the second flat structure 113 and the third connection part 1161, that is, there is no baffle plate spaced on a side that is of the fourth chamber 164 and that faces the fifth chamber 165, so that a device in the fourth chamber 164 extends into the fifth chamber 165 and is electrically connected to the second circuit board 50b.

In an implementation, the heat dissipation fins 15 are disposed on a surface of a side that is of the third connection part 1161 and/or the fourth protrusion part 1162 and that is away from the fifth chamber 165, to improve a heat dissipation capability and heat dissipation efficiency of the third connection part 1161 and/or the fourth protrusion part 1162.

In an implementation, a thermally conductive material may be disposed between the first circuit board 50a and the cover plate 13. For example, the thermally conductive material may be disposed at a position of the first circuit board 50a on which a high-heat-generating power device is electrically connected. This reduces a disposing amount of the thermally conductive material, and effectively reduces heat dissipation costs. In addition, the high-heat-generating power device may transfer heat to the cover plate 13 and then transfer the heat to the outside of the cover plate 13 through the first circuit board 50a and the thermally conductive material. This increases a heat conduction path of the high-heat-generating device, and effectively improves the heat dissipation capability and the heat dissipation efficiency.

The second circuit board 50b is close to the second side plate 122, so that the through-wall terminal 40 on the second circuit board 50b penetrates the second side plate 122 and is electrically connected to an external circuit, thereby reducing an internal cable layout and simplifying assembly. The second circuit board 50b may be electrically connected to the first circuit board 50a through a gold finger, to implement a cable-free assembly design between internal circuits, simplify an assembly process, improve manufacturing efficiency, and help reduce manufacturing costs of the power conversion apparatus 100.

FIG. 7 is a diagram of a three-dimensional structure of the power conversion apparatus 100 according to an embodiment of this application. In an implementation, the fan 20 may alternatively be disposed on the third side plate 123. For example, the fan 20 may be disposed at a position that is on the third side plate 123 and that corresponds to the recess part 111. Optionally, the fan 20 may alternatively be disposed on one or more of the fourth side plate 124, the first side plate 121, and the second side plate 122, and may be specifically disposed based on a position in which heat transfer is concentrated in the power conversion apparatus 100, to improve the heat dissipation capability of the power conversion apparatus 100. A quantity of fans 20 may be increased or decreased according to a heat consumption requirement of the power conversion apparatus 100.

In this application, unless otherwise specified and limited, terms "connection", "fastened", and the like should be understood in a broad sense. For example, "fastened" may be a fixed connection, may be a detachable connection, or may be an integrated connection; may be a mechanical connection, or may be an electrical connection; or may be a direct connection, or may be an indirect connection through an intermediate medium, or may be a connection inside two elements or an interaction relationship between two elements, unless otherwise specified. A person of ordinary skill in the art may understand specific meanings of the foregoing terms in this application based on a specific case.

"First", "second", and various numbers in this specification are merely used for differentiation for ease of description, but are not intended to limit the scope of this application.

It should be understood that sequence numbers of the foregoing processes do not mean execution sequences in various embodiments of this application. The execution sequences of the processes should be determined according to functions and internal logic of the processes, and should not be construed as any limitation on the implementation processes of embodiments of this application.

The foregoing embodiments are merely intended for describing the technical solutions of this application other than limiting this application. Although this application is described in detail with reference to the foregoing embodiments, a person of ordinary skill in the art should understand that modifications may still be made to the technical solutions described in the foregoing embodiments or equivalent replacements may still be made to some technical features thereof, without departing from the scope of the technical solutions of embodiments of this application.

## Claims

1. A power conversion apparatus, comprising a housing, a first circuit board, one or more switching transistors, one or more inductors, and a plurality of capacitors, wherein the first circuit board, the one or more switching transistors, the one or more inductors, and the plurality of capacitors are located in the housing, wherein
the first circuit board is disposed opposite to a base plate of the housing in a first direction;
the one or more switching transistors, the one or more inductors, and the plurality of capacitors are all fastened to the first circuit board and are all located between the first circuit board and the base plate;
the base plate comprises a first chamber, a second chamber, and a third chamber that are sequentially communicated;
the first chamber is configured to accommodate the plurality of capacitors, the second chamber is configured to accommodate the one or more switching transistors, and the third chamber is configured to accommodate the one or more inductors; and
in the first direction, a depth of the second chamber is less than a depth of the first chamber and less than a depth of the third chamber.

2. The power conversion apparatus according to claim 1, wherein the housing comprises the base plate, at least four side plates, and a cover plate, wherein the cover plate is disposed opposite to the base plate in the first direction, and the at least four side plates are connected to edges of the cover plate and edges of the base plate; and
the base plate comprises a plurality of bent structures and a plurality of flat structures, wherein one end of a first bent structure is connected to a first side plate to enclose the first chamber, the other end of the first bent structure is connected to one end of a first flat structure, the first flat structure encloses the second chamber, the one or more switching transistors are located between the first flat structure and the first circuit board, the other end of the first flat structure is connected to a second bent structure, and the second bent structure encloses the third chamber.

3. The power conversion apparatus according to claim 2, wherein the power conversion apparatus comprises a fan, and the fan is disposed on a side that is of the first flat structure and that is away from the cover plate.

4. The power conversion apparatus according to claim 3, wherein the base plate further comprises heat dissipation fins, the heat dissipation fins are disposed on a surface of a side that is of the base plate and that is away from the cover plate; and in the first direction, the fan is disposed opposite to the heat dissipation fins disposed on the first flat structure.

5. The power conversion apparatus according to any one of claims 2 to 4, wherein the first bent structure comprises a first connection part and a first protrusion part, the first connection part is connected between the first protrusion part and the first side plate, the first connection part is farther away from the cover plate in the first direction relative to the first flat structure, one end that is of the first protrusion part and that is away from the first connection part is connected to the first flat structure, the first protrusion part protrudes toward the cover plate in the first direction relative to the first connection part, the first side plate, the first connection part, and the first protrusion part enclose the first chamber, and the plurality of capacitors are accommodated between the first connection part and the first circuit board.

6. The power conversion apparatus according to any one of claims 2 to 5, wherein the second bent structure comprises a second connection part and a second protrusion part, the second connection part is farther away from the cover plate in the first direction relative to the first flat structure, the second protrusion part protrudes toward the cover plate in the first direction relative to the second connection part, the second protrusion part is connected between the first flat structure and the second connection part, the second connection part and the second protrusion part enclose the third chamber, and the one or more inductors are accommodated between the second connection part and the first circuit board.

7. The power conversion apparatus according to claim 6, wherein the second bent structure further comprises a third protrusion part connected to the second connection part, the third protrusion part, the third protrusion part protrudes toward the cover plate in the first direction relative to the second connection part, the third protrusion part is disposed opposite to the second protrusion part, and the third protrusion part, the second connection part, and the second protrusion part enclose the third chamber.

8. The power conversion apparatus according to any one of claims 2 to 7, wherein the base plate further comprises a second flat structure, the second flat structure is connected to the second bent structure, the second flat structure is farther away from the cover plate in the first direction relative to the first flat structure, and the second flat structure encloses a fourth chamber; and the power conversion apparatus further comprises a direct current switch and a relay, both the direct current switch and the relay are disposed on the first circuit board and extend toward the base plate in the first direction, and both the direct current switch and the relay are accommodated in the fourth chamber.

9. The power conversion apparatus according to claim 8, wherein the base plate further comprises a third bent structure, the third bent structure comprises a third connection part and a fourth protrusion part that are connected, the third connection part is farther away from the cover plate in the first direction relative to the second flat structure, the fourth protrusion part protrudes toward the cover plate in the first direction relative to the third connection part, the fourth protrusion part is connected between the second flat structure and the third connection part, one end of the third connection part is connected to a second side plate, the second side plate is disposed opposite to the first side plate, and the third connection part, the fourth protrusion part, and the second side plate enclose a fifth chamber; and the power conversion apparatus further comprises a second circuit board, the second circuit board is connected to and disposed perpendicular to the first circuit board, and the second circuit board is accommodated in the fifth chamber.

10. The power conversion apparatus according to claim 9, wherein the power conversion apparatus further comprises a plurality of through-wall terminals, and the plurality of through-wall terminals penetrate the second side plate and are connected to the second circuit board.

11. The power conversion apparatus according to claim 9 or 10, wherein the base plate, the first side plate, and the second side plate are of an integrally formed structure.
